# EUROPEAN PATENT APPLICATION

(11) **EP 2 722 939 A1**
(43) Date of publication of application: **23.04.2014**
(21) Application number: 12800025.4
(22) Date of filing: 15.06.2012
(51) Int. Cl.: H01R 31/06

(54) **AUDIO SIGNAL RECEIVING AND TRANSFERRING DEVICE**

(30) Priority: 15.06.2011 CN 201110161192
(71) Applicant: Tendyron Corporation, Beijing 100083 (CN)
(72) Inventor: LI, Dongsheng, Beijing 100083 (CN)
(74) Representative: Maiwald Patentanwalts GmbH
(86) International application number: PCT/CN2012/077034
(87) International publication number: WO 2012/171492

(57) **Abstract**

An audio signal transferring device includes an input interface and a USB (Universal Serial Bus) output interface; the device also includes: a boosting unit, a rectifying unit, and a filtering unit; in which, the input interface comprises a first audio signal input pin, which is used for receiving an audio signal sent by an audio signal transmit device connected with the pin, and outputting the audio signal to an input end of the boosting unit; the boosting unit is used for boosting the audio signal input from its input end, and outputting the boosted audio signal through its output end to an input end of the rectifying unit; the rectifying unit is used for rectifying the boosted audio signal input from its output end, and outputting the level obtained from the rectify through its output end to an input end of the filtering unit; and the filtering unit is used for filtering the level input from its input end, and outputting the direct current level obtained from the filtration through its output end to a VBUS (Voltage Bus) pin of the USB output interface.

## Description

### FIELD

The present invention generally relates to an electronic technique field, and more particularly relates to an audio signal receiving device and an audio signal adapter device.

### BACKGROUND

With the development of an audio signal coding/decoding technology, more and more electronic devices transmitting data via an audio interface are produced. For example, the electronic device can be connected with a mobile communication device via a low-resistance voice coil type of loudspeaker interface (such as a headphone interface) of the mobile communication device (such as a mobile phone) for receiving an audio signal output from the mobile communication device.

As an output power of the low-resistance voice coil type of loudspeaker interface is usually very low, except the electronic device (such as a headphone) with low power consumption, the electronic device receiving the audio signal via the low-resistance voice coil type of loudspeaker interface generally needs to use external power source or an internal battery for normal working, which increases a cost of the electronic device and enlarges a volume of the electronic device.

### SUMMARY

The present disclosure provides an audio signal adapter device with a high output power, and an audio signal receiving device connected with the audio signal adapter device.

A new audio signal adapter device is proposed. The audio signal adapter device comprises: an input interface, a USB output interface, a boosting unit, a rectifying unit and a filtering unit, in which the input interface has a first audio signal input pin configured to receive an audio signal sent by an audio signal sending device connected with the input interface and to output the audio signal to an input end of the boosting unit; the boosting unit is configured to boost the audio signal input from the input end of the boosting unit, and to output a boosted audio signal to an input end of the rectifying unit via an output end of the boosting unit; the rectifying unit is configured to rectify the boosted audio signal input from the input end of the rectifying unit to obtain a level, and to output the level to an input end of the filtering unit via an output end of the rectifying unit; and the filtering unit is configured to filter the level input from the input end of the filtering unit to obtain a direct current level, and to output the direct current level to a VBUS pin of the USB output interface via an output end of the filtering unit.

Furthermore, the USB output interface has a D+ pin; the D+ pin is used as an audio signal output pin, connected with the first audio signal input pin, and configured to output the audio signal.

Furthermore, the USB output interface has a D+ pin; the D+ pin is used as an audio signal output pin, connected with the output end of the boosting unit, and configured to output the audio signal.

Furthermore, the input interface further has a MIC pin, connected with a D- pin of the USB output interface; and the D- pin is configured to receive a signal and to output the signal via the MIC pin.

Furthermore, the USB output interface has a D- pin; the D- pin is used as an audio signal output pin, connected with the first audio signal input pin, and configured to output the audio signal.

Furthermore, the USB output interface has a D- pin; the D- pin is used as an audio signal output pin, connected with the output end of the boosting unit, and configured to output the audio signal.

Furthermore, the input interface further has a MIC pin, connected with a D+ pin of the USB output interface; and the D+ pin is configured to receive a signal and to output the signal via the MIC pin.

Furthermore, the boosting unit is a boosting transformer, comprising a primary coil and a secondary coil; one pin of the primary coil is used as the input end of the boosting unit and connected with the first audio signal input pin, and the other pin of the primary coil is grounded; and at least one output pin of the secondary coil is used as the output end of the boosting unit and connected with the input end of the rectifying unit, and a tap of the secondary coil is grounded.

Furthermore, the rectifying unit comprises at least one diode, an anode of the at least one diode is connected with the input end of the rectifying unit, and a cathode of the at least one diode is connected with the output end of the rectifying unit.

Furthermore, the secondary coil of the boosting transformer has two output pins; the input end of the rectifying unit has two input pins; the two output pins of the secondary coil are connected with the two input pins of the rectifying unit respectively; and the rectifying unit comprises two diodes, and anodes of the two diodes are connected with the two input pins of the rectifying unit respectively.

Furthermore, the filtering unit comprises a capacitor; one terminal of the capacitor is connected with the input or output end of the filtering unit; and the input end of the filtering unit is connected with the output end of the filtering unit.

Furthermore, the audio signal adapter device further comprises a signal amplifying unit, in which the D+ pin is connected with the first audio signal input pin via the signal amplifying unit.

Furthermore, the audio signal adapter device further comprises a signal amplifying unit, in which the D+ pin is connected with the output end of the boosting unit via the signal amplifying unit.

Furthermore, the audio signal adapter device further comprises a signal amplifying unit, in which the D- pin is connected with the first audio signal input pin via the signal amplifying unit.

Furthermore, the audio signal adapter device further comprises a signal amplifying unit, in which the D- pin is connected with the output end of the boosting unit via the signal amplifying unit.

Furthermore, the first audio signal input pin comprises a left-channel pin and a right-channel pin.

Furthermore, the boosting unit is a boosting transformer, comprising a primary coil and a secondary coil; one pin of the primary coil is used as the input end of the boosting unit and connected with the first audio signal input pin, and the other pin of the primary coil is grounded; and one output pin of the secondary coil is used as the output end of the boosting unit and connected with the input end of the rectifying unit, and the other output pin of the secondary coil is grounded.

Furthermore, the rectifying unit comprises one diode, an anode of the diode is connected with the input end of the rectifying unit, and a cathode of the diode is connected with the output end of the rectifying unit.

Furthermore, the input interface further has a second audio signal input pin; the USB output interface has an audio signal output pin; the audio signal output pin is connected with the second audio signal input pin and configured to output the audio signal; and the audio signal output pin is a D+ pin or a D- pin.

Furthermore, the audio signal adapter device further comprises a signal amplifying unit, in which the audio signal output pin is connected with the second audio signal input pin via the signal amplifying unit.

The present disclosure further provides an audio signal receiving device, comprising: a signal receiving module, a signal sending module and a USB input interface, in which the signal receiving module is connected with an audio signal input pin of the USB input interface and configured to receive an audio signal via the audio signal input pin; the signal sending module is connected with a signal output pin of the USB input interface and configured to output a signal via the signal output pin; and the audio signal input pin is one of a D+ pin and a D- pin, and the signal output pin is the other one of the D+ pin and the D- pin.

Furthermore, the signal receiving module comprises: a direct current signal isolation unit, a first direct current bias unit, a second direct current bias unit and a comparator; an input end of the direct current signal isolation unit is connected with the audio signal input pin, an output end of the direct current signal isolation unit is connected with the second direct current bias unit, and the direct current signal isolation unit is configured to isolate a direct current level in the audio signal received via the audio signal input pin, and to output the audio signal via the output end thereof; an input end of the second direct current bias unit is connected with the direct current signal isolation unit, an output end of the second direct current bias unit is connected with a negative terminal of the comparator, and the second direct current bias unit is configured to add a direct current bias to the audio signal input from the input end thereof, and to output an audio signal added with the direct current bias via the output end thereof; an output end of the first direct current bias unit is connected with a positive terminal of the comparator, and the first direct current bias unit is configured to output a reference level; and the comparator is configured to output a square wave corresponding to the audio signal via an output end thereof under an action of the reference level input from the positive terminal thereof and the audio signal added with the direct current bias input from the negative terminal thereof.

Furthermore, the signal sending module comprises a tri-state gate and a resistor R2; one terminal of the resistor R2 is connected with the signal output pin, and the other terminal of the resistor R2 is connected with an output end of the tri-state gate; and the tri-state gate is configured to output a signal via an output end thereof under an action of a data signal input from end thereof and a control signal input from an enable end thereof.

Furthermore, the output end and the positive terminal of the comparator are connected via a resistor R7, and the output end of the comparator is connected with a pull-up resistor R8.

Furthermore, the first direct current bias unit comprises: a resistor R3 and a resistor R4; one terminal of the resistor R3 is connected with a first power supply, and the other terminal of the resistor R3 is connected with the resistor 4; one terminal of the resistor R4 is connected with the resistor R3 and the output end of the first direct current bias unit, and the other terminal of the resistor R4 is grounded; the second direct current bias unit comprises: a resistor R5 and a resistor R6; one terminal of the resistor R5 is connected with a second power supply, and the other terminal of the resistor R5 is connected with the resistor R6; one terminal of the resistor R6 is connected with the resistor R5 and the output end of the second direct current bias unit, and the other terminal of the resistor 6 is grounded; and an output voltage of the first power supply connected with the first direct current bias unit is equal to an output voltage of the second power supply connected with the second direct current bias unit, a resistance of the resistor R3 is equal to a resistance of the resistor R5, and a resistance of the resistor R4 is equal to a resistance of the resistor R6.

In conclusion, the embodiments of the present disclosure realize feeding function via an audio signal with a relatively low hardware cost. The audio signal receiving device, used in combination with the audio signal adapter device (e.g., an audio cable or an audio adapter) of the present disclosure, can obtain power while receiving the audio signal and sending a signal to an audio signal sending device, which reduces a cost of the audio signal receiving device and decreases a volume of the audio signal receiving device.

Furthermore, the audio signal adapter device of the present disclosure further comprising the USB output interface may be connected with the audio signal receiving device having a USB interface, so that the audio signal receiving device may be powered via the VBUS pin of the USB interface. In addition, one of the D+ pin and the D- pin is used as the audio signal input pin, and the other of the D+ pin and the D- pin is used as the audio signal output pin, so that a both-way communication between the audio signal sending device and the audio signal receiving device is realized.

### BRIEF DESCRIPTION OF THE DRAWINGS

Fig. 1 is a schematic diagram of an audio signal adapter device according to a first embodiment of the present disclosure;
Fig. 2 is a schematic diagram of an audio signal receiving device according to the first embodiment of the present disclosure;
Fig. 3 is a schematic diagram of an audio signal adapter device according to a second embodiment of the present disclosure;
Fig. 4 is a schematic diagram of an audio signal adapter device according to a third embodiment of the present disclosure;
Fig. 5 is a schematic diagram of an audio signal adapter device according to a fourth embodiment of the present disclosure;
Fig. 6 is a schematic diagram of an audio signal adapter device according to a fifth embodiment of the present disclosure;
Fig. 7 is a schematic diagram of an audio signal adapter device according to a sixth embodiment of the present disclosure;
Fig. 8 is a schematic diagram of an audio signal receiving device according to the sixth embodiment of the present disclosure;
Fig. 9 is a schematic diagram of an audio signal adapter device according to a seventh embodiment of the present disclosure;
Fig. 10 is a schematic diagram of an audio signal adapter device according to an eighth embodiment of the present disclosure;
Fig. 11 is a schematic diagram of an audio signal adapter device according to a ninth embodiment of the present disclosure;
Fig. 12 is a schematic diagram of an audio signal adapter device according to a tenth embodiment of the present disclosure.

### DETAILED DESCRIPTION

The present disclosure will be described below in detail with reference to drawings and embodiments.

The audio signal adapter device of the present disclosure may be an audio cable, an audio adapter cable or an audio adapter.

### FIRST EMBODIMENT

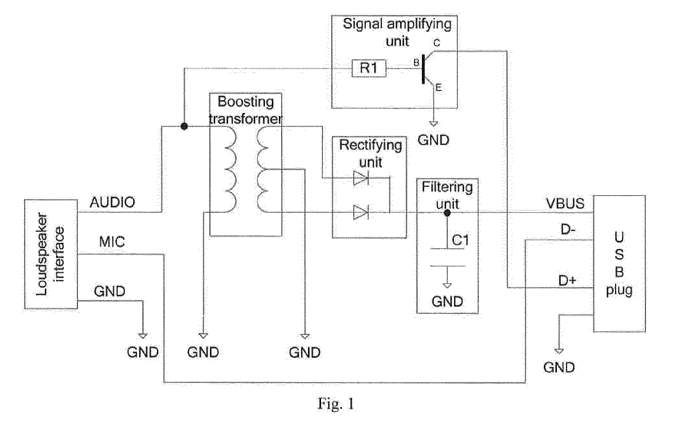

Fig. 1 is a schematic diagram of an audio signal adapter device according to a first embodiment of the present disclosure. As shown in Fig. 1, the audio signal adapter device comprises: a loudspeaker interface, a boosting unit (e.g., a boosting transformer shown in Fig. 1), a rectifying unit, a filtering unit, and a USB output interface (e.g., a USB plug shown in Fig. 1).

The loudspeaker interface connected with an audio signal sending device (such as a mobile phone) is configured to receive an audio signal output from the audio signal sending device, and to output a signal to the audio signal sending device.

The loudspeaker interface may be a low-resistance voice coil type of loudspeaker interface (e.g., a headphone interface), having: an audio signal input pin (e.g., an AUDIO pin shown in Fig.1), a microphone pin (e.g., a MIC pin shown in Fig.1) and a ground pin (e.g., a GND pin shown in Fig. 1).

The audio signal input pin of the loudspeaker interface connected with one pin of a primary coil of the boosting transformer is configured to receive the audio signal sent from the audio signal sending device (e.g., the mobile phone) and to output the audio signal to the one pin of the primary coil. The ground pin of the loudspeaker interface is grounded.

The boosting transformer comprises the primary coil and a secondary coil, and is configured to raise an input voltage (commonly about 1V) at an input end (the primary coil) to an output voltage (for example, larger than or equal to 5V) at an output end (the secondary coil).

The primary coil of the boosting transformer has two pins, one of which is connected with the audio signal input pin of the loudspeaker interface, and the other of which is grounded.

The output coil (i.e., the secondary coil) of the boosting transformer has two output pins and one tap, in which the two output pins are connected with two input pins of an input end of the rectifying unit respectively, and the tap is grounded.

The rectifying unit has the input end and an output end, and is configured to rectify an alternating current level input from the input end thereof, and to output the rectified level via the output end thereof.

In this embodiment, the rectifying unit has two input pins of the input end, and one output pin of the output end. Accordingly, the rectifying unit comprises two diodes, positive poles of the two diodes are connected with the two input pins of the rectifying unit respectively, and negative poles of the two diodes are connected with the output pin of the rectifying unit.

The filtering unit has an input end and an output end, and is configured to convert the rectified level input from the input end thereof to a smooth direct current level, and to output the smooth direct current level via the output end thereof.

In this embodiment, the input end of the filtering unit is connected with the output end of the rectifying unit, and the output end of the filtering unit is connected with the power supply output pin (i.e., a VBUS pin of the USB output interface) to supply power to a USB device connected with the filtering unit.

In this embodiment, the input end and the output end of the filtering unit are connected. The filtering unit comprises a capacitor C1: one end of the capacitor C1 is connected with the input/output end of the filtering unit, and the other end of the capacitor C1 is grounded.

The USB output interface has: a power supply output pin (i.e., the VBUS pin), an audio signal output pin, a signal input pin, and a ground pin (i.e., a GND pin).

In this embodiment, the audio signal output pin is a D+ pin, and the signal input pin is a D-pin.

In this embodiment, the audio signal output pin (i.e., the D+ pin) is connected with the audio signal input pin (i.e., the AUDIO pin) of the loudspeaker interface, and configured to output the audio signal to the USB device connected with the audio signal output pin.

Alternatively, a signal amplifying unit may be connected between the audio signal output pin (i.e., the D+ pin) and the audio signal input pin of the loudspeaker interface, that is, an input end of the signal amplifying unit is connected with the audio signal input pin of the loudspeaker interface, and an output end of the signal amplifying unit is connected with the audio signal output pin (i.e., the D+ pin) to output an amplified audio signal.

In this embodiment, the signal input pin (i.e., the D- pin) is connected with the microphone pin (i.e., the MIC pin) of the loudspeaker interface, and configured to send a signal to the audio signal sending device connected with the loudspeaker interface.

The ground pin of the USB output interface is grounded.

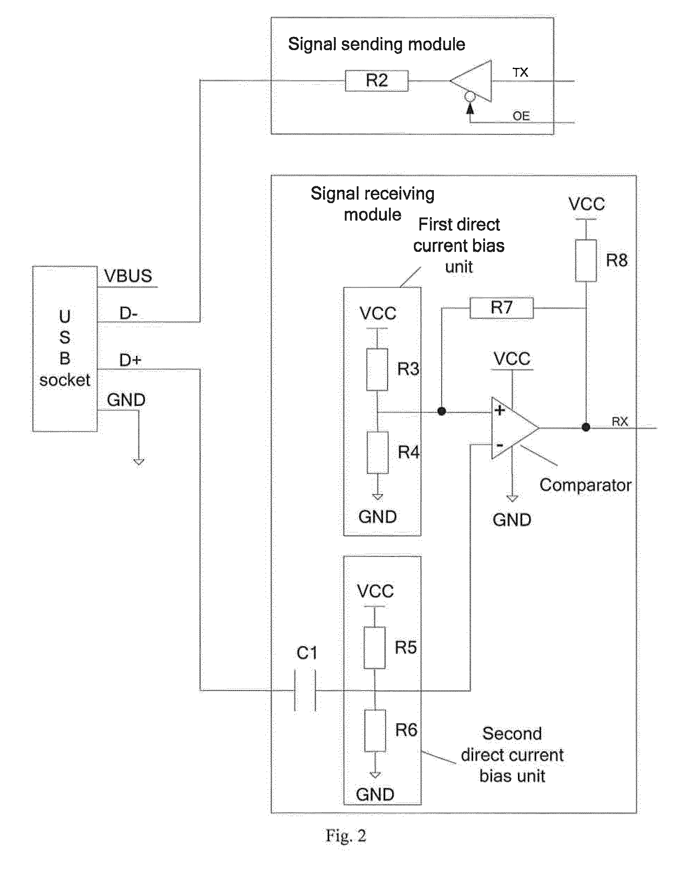

Fig. 2 is a schematic diagram of an audio signal receiving device according to the first embodiment of the present disclosure. As shown in Fig. 2, the audio signal receiving device comprises: a USB input interface (e.g., a USB socket shown in Fig. 1), a signal receiving module, and a signal sending module.

The USB input interface has: a power supply input pin (i.e., a VBUS pin), an audio signal input pin, a signal output pin, and a ground pin (i.e., a GND pin).

In this embodiment, the audio signal input pin is a D+ pin, and the signal output pin is a D-pin.

The ground pin of the USB input interface is grounded.

An input end of the signal receiving module is connected with the audio signal input pin. The signal receiving module is configured to receive the audio signal via the audio signal input pin, and to output the audio signal via an output end thereof.

The signal receiving module comprises: a direct current signal isolation unit, a first direct current bias unit, a second direct current bias unit, and a comparator.

In this embodiment, the direct current signal isolation unit comprising a capacitor C1 is configured to isolate a direct current level. One terminal (an input end of the direct current signal isolation unit) of the capacitor C1 is connected with the audio signal input pin, and the other terminal (an output end of the direct current signal isolation unit) of the capacitor C1 is connected with the second direct current bias unit.

A capacitance of the capacitor C1 may be 0.1 µF.

An output end of the first direct current bias unit is connected with a positive terminal of the comparator, and the first direct current bias unit is configured to output a reference level to the comparator.

In this embodiment, the first direct current bias unit comprises: a resistor R3 and a resistor R4. One terminal of the resistor R3 is connected with a first power supply, and the other terminal of the resistor R3 is connected with the resistor R4. One terminal of the resistor R4 is connected with the resistor R3 and the output end of the first direct current bias unit, and the other terminal of the resistor R4 is grounded.

An input end of the second direct current bias unit is connected with the output end of the direct current signal isolation unit, and an output end of the second direct current bias unit is connected with a negative terminal of the comparator. The second direct current bias unit is configured to add a direct current bias to the audio signal input from the input end thereof so as to raise a minimum voltage of the audio signal to over 0 volt, and to output an audio signal added with the direct current bias via the output end thereof.

In this embodiment, the second direct current bias unit comprises: a resistor R5 and a resistor R6. One terminal of the resistor R5 is connected with a second power supply, and the other terminal of the resistor R5 is connected with the resistor R6. One terminal of the resistor R6 is connected with the input end of the second direct current bias unit, the resistor R5 and the output end of the second direct current bias unit, and the other terminal of the resistor R6 is grounded.

An output voltage of the first power supply connected with the first direct current bias unit is equal to an output voltage of the second power supply connected with the second direct current bias unit, a resistance of the resistor R3 is equal to a resistance of the resistor R5, and a resistance of the resistor R4 is equal to a resistance of the resistor R6.

In this embodiment, the resistance of the resistor R3 and the resistor R5 may be 150K ohms, and the resistance of the resistor R4 and the resistor R6 may be 15K ohms.

As described above, the positive terminal of the comparator is connected with the output end of the first direct current bias unit, the negative terminal of the comparator is connected with the output end of the second direct current bias unit, and an output end of the comparator is connected with the output end of the signal receiving module (that is, the output end of the comparator is used as the output end of the signal receiving module) to output a square wave corresponding to the audio signal.

In this embodiment, in order to make the comparator output a stable signal, the output end and the positive terminal of the comparator are connected via a resistor R7 to form a loop, and the output end of the comparator is connected with a pull-up resistor R8.

A resistance of the resistor R7 may be 1.5M ohms, and a resistance of the resistor R8 may be 20K ohms.

An output end of the signal sending module connected with the signal output pin is configured to output a signal.

In this embodiment, the signal sending module comprises a tri-state gate and a resistor R2.

One terminal of the resistor R2 is connected with the output end of the signal sending module, and the other terminal of the resistor R2 is connected with an output end of the tri-state gate.

The tri-state gate is configured to output the signal via the output end thereof under an action of a data signal input from an input end thereof and a control signal input from an enable end thereof.

### SECOND EMBODIMENT

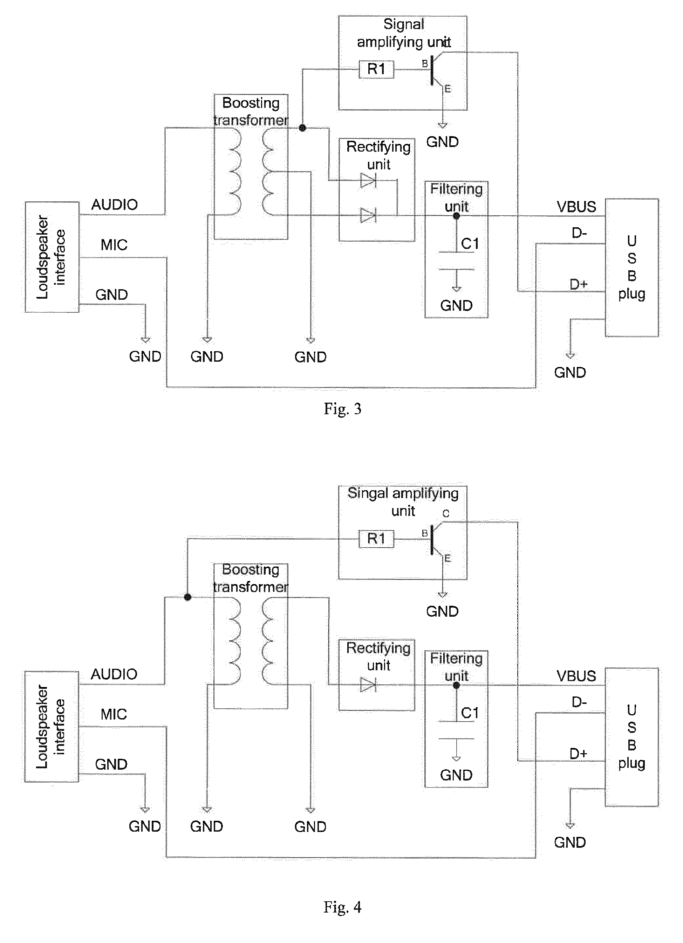

Fig. 3 is a schematic diagram of an audio signal adapter device according to a second embodiment of the present disclosure. As shown in Fig. 3, the differences between the audio signal adapter devices in the second embodiment and in the first embodiment are as follows.

In the second embodiment, the audio signal output pin (i.e., D+ pin) is connected with any one of output pins of the output end of the boosting transformer, and configured to output an audio signal to the USB device connected with the audio signal output pin.

The audio signal receiving device in the second embodiment is identical with that in the first embodiment.

### THIRD EMBODIMENT

Fig. 4 is a schematic diagram of an audio signal adapter device according to a third embodiment of the present disclosure. As shown in Fig. 4, the differences between the audio signal adapter devices in the third embodiment and in the first embodiment are as follows.

In the third embodiment, only one output pin of the secondary coil of the boosting transformer is connected with the input pin of the rectifying unit. Thus, the rectifying unit just need one input pin and comprises just one diode.

Apparently, compared to the first embodiment, although half of electric energy of the secondary coil of the boosting transformer will be lost, a circuit structure may be simplified and a hardware cost may be reduced by using this embodiment.

In this embodiment, the other output pin of the secondary coil of the boosting transformer is grounded, and the tap is not included in the boosting transformer.

The audio signal receiving device in the third embodiment is identical with that in the first embodiment.

### FOURTH EMBODIMENT

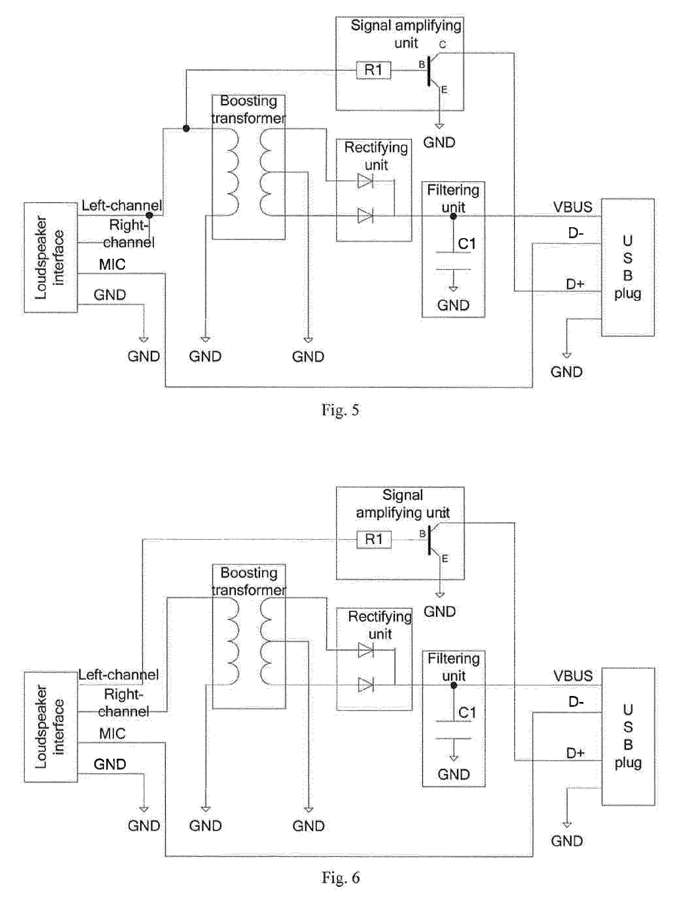

Fig. 5 is a schematic diagram of an audio signal adapter device according to a fourth embodiment of the present disclosure. As shown in Fig. 5, the differences between the audio signal adapter devices in the fourth embodiment and in the first embodiment are as follows.

In the fourth embodiment, the audio signal input pin of the loudspeaker interface comprises a left-channel pin and a right-channel pin, which are connected with the same pin of the primary coil of the boosting transformer.

The audio signal receiving device in the fourth embodiment is identical with that in the first embodiment.

### FIFTH EMBODIMENT

Fig. 6 is a schematic diagram of an audio signal adapter device according to a fifth embodiment of the present disclosure. As shown in Fig. 6, the differences between the audio signal adapter devices in the fifth embodiment and in the fourth embodiment are as follows.

In the fifth embodiment, the audio signal input pin of the loudspeaker interface comprises a left-channel pin and a right-channel pin. The left-channel pin connected with the input end of the signal amplifying unit is configured to output an audio signal, and the right-channel pin connected with one pin of the primary coil of the boosting transformer is configured to output power.

Certainly, alternatively, the right-channel pin connected with the input end of the signal amplifying unit is configured to output an audio signal, and the left-channel pin connected with one pin of the primary coil of the boosting transformer is configured to output power.

The audio signal receiving device in the fifth embodiment is identical with that in the first embodiment.

### SIXTH EMBODIMENT

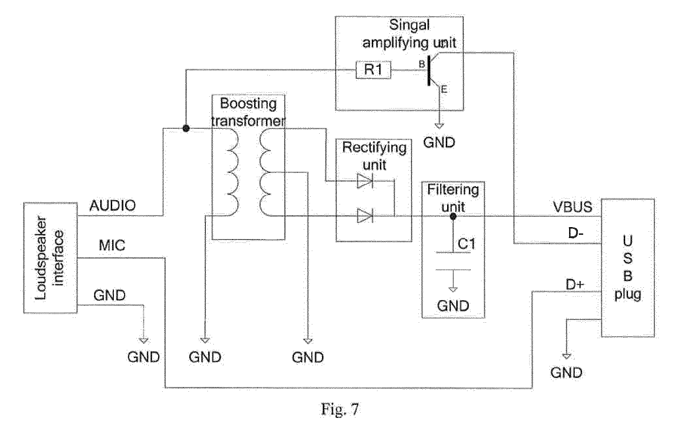

Fig. 7 is a schematic diagram of an audio signal adapter device according to a sixth embodiment of the present disclosure. As shown in Fig. 7, the differences between the audio signal adapter devices in the sixth embodiment and in the first embodiment are as follows.

In the sixth embodiment, the audio signal output pin is the D- pin, and the signal input pin is the D+ pin. That is, in this embodiment, the audio signal output pin (i.e., the D- pin) is connected with the audio signal input pin (i.e., the AUDIO pin) of the loudspeaker interface directly or via the signal amplifying unit, and configured to output the audio signal to the USB device connected with the audio signal output pin; and the signal input pin (i.e., the D+ pin) is connected with the microphone pin (i.e., the MIC pin) of the loudspeaker interface, and configured to send the signal to the audio signal sending device connected with the loudspeaker interface.

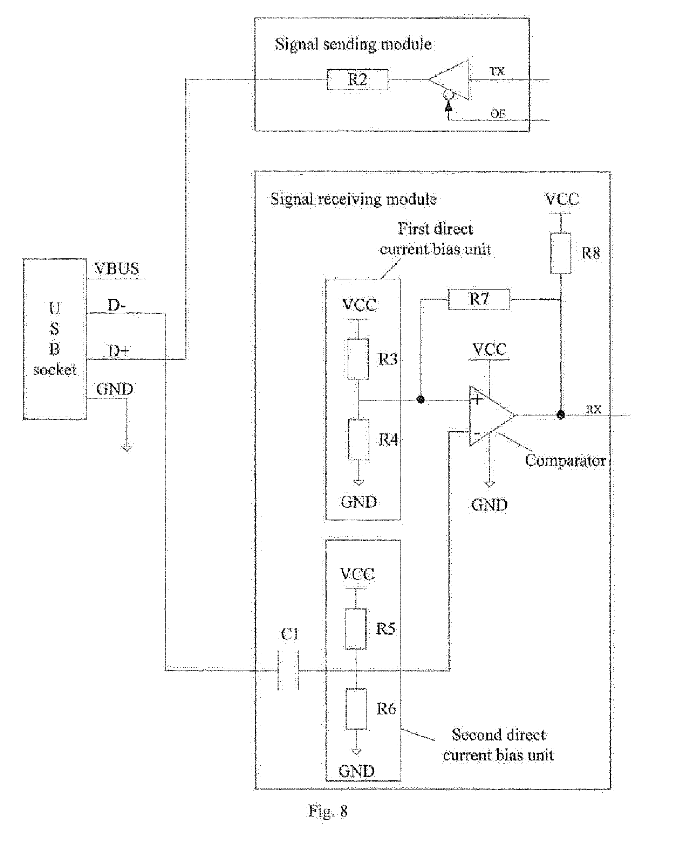

Fig. 8 is a schematic diagram of an audio signal receiving device according to the sixth embodiment of the present disclosure. As shown in Fig. 8, the differences between the audio signal receiving devices in the sixth embodiment and in the first embodiment are as follows.

In the sixth embodiment, the audio signal input pin is the D- pin, and the signal output pin is the D+ pin. That is, in this embodiment, the D- pin is connected with the input end of the signal receiving module, and the D+ pin is connected with the input end of the signal sending module.

### SEVENTH EMBODIMENT

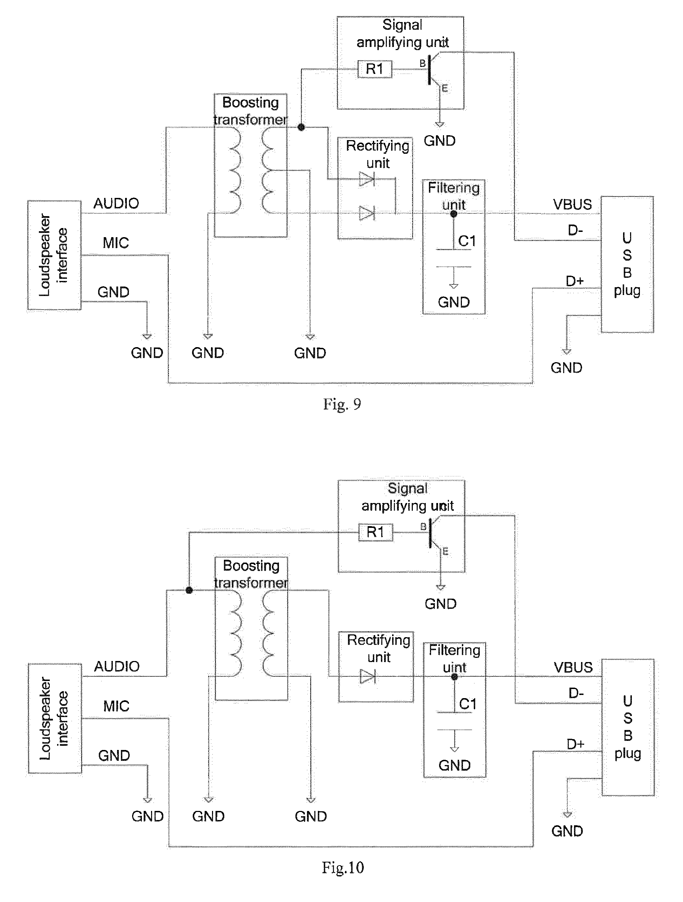

Fig. 9 is a schematic diagram of an audio signal adapter device according to a seventh embodiment of the present disclosure. As shown in Fig. 9, the differences between the audio signal adapter devices in the seventh embodiment and in the second embodiment are as follows.

In the seventh embodiment, the audio signal output pin is the D- pin, and the signal input pin is the D+ pin. That is, in this embodiment, the audio signal output pin (i.e., the D- pin) is connected with any one of output pins of the output end of the boosting transformer directly or via the signal amplifying unit, and configured to output the audio signal to the USB device connected with the audio signal output pin; and the audio signal input pin (i.e., the D+ pin) is connected with the microphone pin (i.e., the MIC pin) of the loudspeaker interface, and configured to send the signal to the audio signal sending device connected with the loudspeaker interface.

The audio signal receiving device in the seventh embodiment is identical with that in the sixth embodiment.

### EIGHTH EMBODIMENT

Fig. 10 is a schematic diagram of an audio signal adapter device according to an eighth embodiment of the present disclosure. As shown in Fig. 10, the differences between the audio signal adapter devices in the eighth embodiment and in the third embodiment are as follows.

In the eighth embodiment, the audio signal output pin is the D- pin, and the signal input pin is the D+ pin. That is, in this embodiment, the audio signal output pin (i.e., the D- pin) is connected with the audio signal input pin (i.e., the AUDIO pin) of the loudspeaker interface directly or via the signal amplifying unit, and configured to output the audio signal to the USB device connected with the audio signal output pin; and the signal input pin (i.e., the D+ pin) is connected with the microphone pin (i.e., the MIC pin) of the loudspeaker interface, and configured to send the signal to the audio signal sending device connected with the loudspeaker interface.

The audio signal receiving device in the eighth embodiment is identical with that in the sixth embodiment.

### NINTH EMBODIMENT

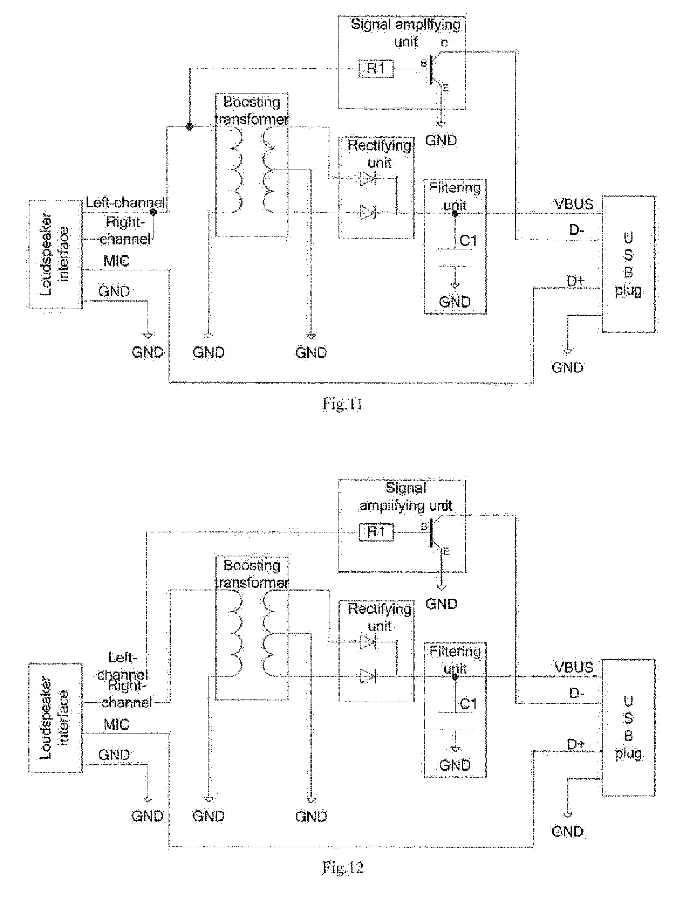

Fig. 11 is a schematic diagram of an audio signal adapter device according to a ninth embodiment of the present disclosure. As shown in Fig. 11, the differences between the audio signal adapter devices in the ninth embodiment and in the fourth embodiment are as follows.

In the ninth embodiment, the audio signal output pin is the D- pin, and the signal input pin is the D+ pin. That is, in this embodiment, the audio signal output pin (i.e., the D- pin) is connected with two audio signal input pins of the loudspeaker interface directly or via the signal amplifying unit, and configured to output the audio signal to the USB device connected with the audio signal output pin; and the signal input pin (i.e., the D+ pin) is connected with the microphone pin (i.e., the MIC pin) of the loudspeaker interface, and configured to send the signal to the audio signal sending device connected with the loudspeaker interface.

The audio signal receiving device in the ninth embodiment is identical with that in the sixth embodiment.

### TENTH EMBODIMENT

Fig. 12 is a schematic diagram of an audio signal adapter device according to a tenth embodiment of the present disclosure. As shown in Fig. 12, the differences between the audio signal adapter devices in the tenth embodiment and in the fifth embodiment are as follows.

In the tenth embodiment, the audio signal output pin is the D- pin, and the signal input pin is the D+ pin. That is, in this embodiment, the audio signal output pin (i.e., the D- pin) is connected with one audio signal input pin (e.g., right-channel pin) of the loudspeaker interface directly or via the signal amplifying unit, and configured to output the audio signal to the USB device connected with the audio signal output pin; and the signal input pin (i.e., the D+ pin) is connected with the microphone pin (i.e., the MIC pin) of the loudspeaker interface, and configured to send the signal to the audio signal sending device connected with the loudspeaker interface.

The audio signal receiving device in the tenth embodiment is identical with that in the sixth embodiment.

The embodiments of the present disclosure realize feeding function via an audio signal with a relatively low hardware cost. The audio signal receiving device, used in combination with the audio signal adapter device of the present disclosure, can obtain power while receiving the audio signal and sending a signal to an audio signal sending device, which reduces a cost of the audio signal receiving device and decreases a volume of the audio signal receiving device.

Furthermore, the audio signal adapter device of the present disclosure further comprising the USB output interface may be connected with the audio signal receiving device having a USB interface, so that the audio signal receiving device may be powered via the VBUS pin of the USB interface. In addition, one of the D+ pin and the D- pin is used as the audio signal input pin, and the other of the D+ pin and the D- pin is used as the audio signal output pin, so that a both-way communication between the audio signal sending device and the audio signal receiving device is realized.

Certainly, according to a basic principle of the present disclosure, the loudspeaker interface in above embodiments may be replaced by other types of input interfaces having an audio signal input pin, a MIC pin and a ground pin.

Furthermore, the above input interface may be mounted on the audio signal sending device.

The above input interface may comprise a plurality of plugs, such as an audio signal plug comprising the audio signal input pin and a MIC plug comprising the MIC pin.

Those skilled in the art shall understand that all or parts of the steps in the above exemplifying method of the present disclosure may be achieved by commanding the related hardware with programs. The programs may be stored in a computer readable storage medium, and the programs comprise one or a combination of the steps in the method embodiments of the present disclosure when run on a computer.

In addition, each function cell of the embodiments of the present disclosure may be integrated in a processing module, or these cells may be separate physical existence, or two or more cells are integrated in a processing module. The integrated module may be realized in a form of hardware or in a form of software function modules. When the integrated module is realized in a form of software function module and is sold or used as a standalone product, the integrated module may be stored in a computer readable storage medium.

The storage medium mentioned above may be read-only memories, magnetic disks or CD, etc.

Although explanatory embodiments have been shown and described, it would be appreciated by those skilled in the art that the above embodiments cannot be construed to limit the present invention, and changes, alternatives, and modifications can be made in the embodiments without departing from spirit, principles and scope of the present invention.

## Claims

1. An audio signal adapter device, comprising: an input interface, a USB output interface, a boosting unit, a rectifying unit and a filtering unit, wherein
the input interface has a first audio signal input pin configured to receive an audio signal sent by an audio signal sending device connected with the input interface and to output the audio signal to an input end of the boosting unit;
the boosting unit is configured to boost the audio signal input from the input end of the boosting unit, and to output a boosted audio signal to an input end of the rectifying unit via an output end of the boosting unit;
the rectifying unit is configured to rectify the boosted audio signal input from the input end of the rectifying unit to obtain a level, and to output the level to an input end of the filtering unit via an output end of the rectifying unit; and
the filtering unit is configured to filter the level input from the input end of the filtering unit to obtain a direct current level, and to output the direct current level to a VBUS pin of the USB output interface via an output end of the filtering unit.

2. The audio signal adapter device according to claim 1, wherein
the USB output interface has a D+ pin;
the D+ pin is used as an audio signal output pin, connected with the first audio signal input pin, and configured to output the audio signal.

3. The audio signal adapter device according to claim 1, wherein
the USB output interface has a D+ pin;
the D+ pin is used as an audio signal output pin, connected with the output end of the boosting unit, and configured to output the audio signal.

4. The audio signal adapter device according to any of claims 1-3, wherein
the input interface further has a MIC pin, connected with a D- pin of the USB output interface; and
the D- pin is configured to receive a signal and to output the signal via the MIC pin.

5. The audio signal adapter device according to claim 1, wherein
the USB output interface has a D- pin;
the D- pin is used as an audio signal output pin, connected with the first audio signal input pin, and configured to output the audio signal.

6. The audio signal adapter device according to claim 1, wherein
the USB output interface has a D- pin;
the D- pin is used as an audio signal output pin, connected with the output end of the boosting unit, and configured to output the audio signal.

7. The audio signal adapter device according to any of claims 1, 5 and 6, wherein
the input interface further has a MIC pin, connected with a D+ pin of the USB output interface; and
the D+ pin is configured to receive a signal and to output the signal via the MIC pin.

8. The audio signal adapter device according to claim 1, wherein
the boosting unit is a boosting transformer, comprising a primary coil and a secondary coil;
one pin of the primary coil is used as the input end of the boosting unit and connected with the first audio signal pin, and the other pin of the primary coil is grounded; and
at least one output pin of the secondary coil is used as the output end of the boosting unit and connected with the input end of the rectifying unit, and a tap of the secondary coil is grounded.

9. The audio signal adapter device according to claim 8, wherein
the rectifying unit comprises at least one diode, an anode of the at least one diode is connected with the input end of the rectifying unit, and a cathode of the at least one diode is connected with the output end of the rectifying unit.

10. The audio signal adapter device according to claim 9, wherein
the secondary coil of the boosting transformer has two output pins;
the input end of the rectifying unit has two input pins;
the two output pins of the secondary coil are connected with the two input pins of the rectifying unit respectively; and
the rectifying unit comprises two diodes, and anodes of the two diodes are connected with the two input pins of the rectifying unit respectively.

11. The audio signal adapter device according to claim 1, wherein
the filtering unit comprises a capacitor;
one terminal of the capacitor is connected with the input or output end of the filtering unit; and
the input end of the filtering unit is connected with the output end of the filtering unit.

12. The audio signal adapter device according to claim 2, further comprising a signal amplifying unit, wherein the D+ pin is connected with the first audio signal input pin via the signal amplifying unit.

13. The audio signal adapter device according to claim 3, further comprising a signal amplifying unit, wherein the D+ pin is connected with the output end of the boosting unit via the signal amplifying unit.

14. The audio signal adapter device according to claim 5, further comprising a signal amplifying unit, wherein the D- pin is connected with the first audio signal input pin via the signal amplifying unit.

15. The audio signal adapter device according to claim 6, further comprising a signal amplifying unit, wherein the D- pin is connected with the output end of the boosting unit via the signal amplifying unit.

16. The audio signal adapter device according to any of claims 1, 2, 5, 8, 12 and 14, wherein the first audio signal input pin comprises a left-channel pin and a right-channel pin.

17. The audio signal adapter device according to claim 1, wherein
the boosting unit is a boosting transformer, comprising a primary coil and a secondary coil;
one pin of the primary coil is used as the input end of the boosting unit and connected with the first audio signal input pin, and the other pin of the primary coil is grounded; and
one output pin of the secondary coil is used as the output end of the boosting unit and connected with the input end of the rectifying unit, and the other output pin of the secondary coil is grounded.

18. The audio signal adapter device according to claim 17, wherein the rectifying unit comprises one diode, an anode of the diode is connected with the input end of the rectifying unit, and a cathode of the diode is connected with the output end of the rectifying unit.

19. The audio signal adapter device according to claim 1, wherein
the input interface further has a second audio signal input pin;
the USB output interface has an audio signal output pin;
the audio signal output pin is connected with the second audio signal input pin and configured to output the audio signal; and
the audio signal output pin is a D+ pin or a D- pin.

20. The audio signal adapter device according to claim 19, further comprising a signal amplifying unit, wherein the audio signal output pin is connected with the second audio signal input pin via the signal amplifying unit.

21. An audio signal receiving device, comprising: a signal receiving module, a signal sending module and a USB input interface, wherein
the signal receiving module is connected with an audio signal input pin of the USB input interface and configured to receive an audio signal via the audio signal input pin;
the signal sending module is connected with a signal output pin of the USB input interface and configured to output a signal via the signal output pin; and
the audio signal input pin is one of a D+ pin and a D- pin, and the signal output pin is the other one of the D+ pin and the D- pin.

22. The audio signal receiving device according to claim 21, wherein
the signal receiving module comprises: a direct current signal isolation unit, a first direct current bias unit, a second direct current bias unit and a comparator;
an input end of the direct current signal isolation unit is connected with the audio signal input pin, an output end of the direct current signal isolation unit is connected with the second direct current bias unit, and the direct current signal isolation unit is configured to isolate a direct current level in the audio signal received via the audio signal input pin, and to output the audio signal via the output end thereof;
an input end of the second direct current bias unit is connected with the direct current signal isolation unit, an output end of the second direct current bias unit is connected with a negative terminal of the comparator, and the second direct current bias unit is configured to add a direct current bias to the audio signal input from the input end thereof, and to output an audio signal added with the direct current bias via the output end thereof;
an output end of the first direct current bias unit is connected with a positive terminal of the comparator, and the first direct current bias unit is configured to output a reference level; and
the comparator is configured to output a square wave corresponding to the audio signal via an output end thereof under an action of the reference level input from the positive terminal thereof and the audio signal added with the direct current bias input from the negative terminal thereof.

23. The audio signal receiving device according to claim 21, wherein
the signal sending module comprises a tri-state gate and a resistor R2;
one terminal of the resistor R2 is connected with the signal output pin, and the other terminal of the resistor R2 is connected with an output end of the tri-state gate; and
the tri-state gate is configured to output a signal via an output end thereof under an action of a data signal input from an input end thereof and a control signal input from an enable end thereof.

24. The audio signal receiving device according to claim 22, wherein
the output end and the positive terminal of the comparator are connected via a resistor R7, and the output end of the comparator is connected with a pull-up resistor R8.

25. The audio signal receiving device according to claim 22, wherein
the first direct current bias unit comprises: a resistor R3 and a resistor R4;
one terminal of the resistor R3 is connected with a first power supply, and the other terminal of the resistor R3 is connected with the resistor R4;
one terminal of the resistor R4 is connected with the resistor R3 and the output end of the first direct current bias unit, and the other terminal of the resistor R4 is grounded;
the second direct current bias unit comprises: a resistor R5 and a resistor R6;
one terminal of the resistor R5 is connected with a second power supply, and the other terminal of the resistor R5 is connected with the resistor R6;
one terminal of the resistor R6 is connected with the resistor R5 and the output end of the second direct current bias unit, and the other terminal of the resistor R6 is grounded; and
an output voltage of the first power supply connected with the first direct current bias unit is equal to an output voltage of the second power supply connected with the second direct current bias unit, a resistance of the resistor R3 is equal to a resistance of the resistor R5, and a resistance of the resistor R4 is equal to a resistance of the resistor R6.
